(19) **Europäisches Patentamt**

**European Patent Office**

**Office européen des brevets**

(11) **EP 1 017 165 A1**

(12) **DEMANDE DE BREVET EUROPEEN**

(43) Date de publication:
**05.07.2000 Bulletin 2000/27**

(51) Int. Cl.⁷: **H03G 3/00**, **H03G 1/00**

(21) Numéro de dépôt: **98460066.8**

(22) Date de dépôt: **31.12.1998**

(84) Etats contractants désignés:
**AT BE CH CY DE DK ES FI FR GB GR IE IT LI LU MC NL PT SE**
Etats d'extension désignés:
**AL LT LV MK RO SI**

(71) Demandeur:
**TRT Lucent Technologies (SA)**
**92359 Le Plessis Robinson (FR)**

(72) Inventeurs:
• **Giguet,Jean-Louis**
**75015 Paris (FR)**

• Roux,Pascal
**77410 Claye-Souilly (FR)**
• Laffont,Jean
**78390 Bois d'Arcy (FR)**
• Achemaoui,Anissa
**92220 Bagneux (FR)**

(74) Mandataire: **Ballot, Paul**
**Cabinet Ballot-Schmit,**
**4 Rue Général Hoche**
**56100 Lorient (FR)**

(54) **Procédé de réglage de la puissance de sortie d'un amplificateur de puissance**

(57) La présente invention concerne un procédé de réglage du niveau de puissance de sortie d'un amplificateur de puissance. Il consiste à régler le niveau de puissance de sortie de l'amplificateur en modifiant la polarisation des transistors de ce dernier. Avantageuse-ment, on agit sur la tension de polarisation de drain et de grille des transistors.

Applications : émetteurs radio.

FIG.2

**Description**

La présente invention concerne un procédé de réglage du niveau de puissance de sortie d'un amplificateur de puissance.

L'invention est tout particulièrement applicable à l'amplification de signaux au niveau de l'étage de sortie d'émetteurs radio.

L'étage de sortie d'un émetteur radio comporte généralement un amplificateur de puissance chargé de délivrer à la fréquence d'émission un signal d'un niveau de puissance donné. Diverses techniques sont connues pour régler ce niveau de puissance de sortie. On peut par exemple placer un atténuateur mécanique variable entre la sortie de l'amplificateur de puissance et l'antenne de l'émetteur.

Il existe également des émetteurs dans lesquels l'amplificateur de puissance est muni de moyens de détection du niveau de puissance à la sortie de l'amplificateur et d'une boucle de rétroaction destinée à commander soit l'atténuation d'un atténuateur variable, soit le gain d'un amplificateur à gain variable placé en amont dans la chaîne d'émission.

La présente invention procède d'une recherche menée relativement au réglage du niveau de puissance de sortie des amplificateurs de puissance en vue d'atteindre les objectifs suivants : simplicité de la mise en oeuvre du réglage; bonne précision de réglage du niveau de puissance de sortie; bonne aptitude à traiter les signaux forts et les signaux faibles (grande dynamique).

Aussi, l'invention a pour objet un procédé de réglage du niveau de puissance de sortie d'un amplificateur de puissance, lequel amplificateur de puissance comporte une pluralité de transistors de puissance, caractérisé en ce qu'il consiste à agir sur la polarisation du drain de ladite pluralité de transistors de l'amplificateur de puissance.

Ainsi, selon l'invention, ce réglage est directement effectué au niveau de l'amplificateur de puissance en modifiant la polarisation de ses transistors.

Avantageusement, on modifie également la polarisation de grille de ces transistors pour améliorer le comportement en température de l'amplificateur.

D'autres caractéristiques et avantages de l'invention apparaîtront à la lecture de la description détaillée qui suit et qui est faite en référence aux dessins annexés, parmi lesquels :

- la figure 1 représente un schéma simplifié d'un amplificateur de puissance;
- la figure 2 représente trois courbes de la puissance de sortie en fonction de la puissance d'entrée obtenues avec trois polarisations de transistors différentes;
- la figure 3 représente une courbe de puissance de sortie en fonction du courant drain-source Ids des transistors de l'amplificateur;

- la figure 4 représente un exemple de lois Vgs=f(Vds) et Ids=f(Vds) définies de manière empirique pour régler au mieux la puissance de sortie de l'amplificateur de la figure 1.

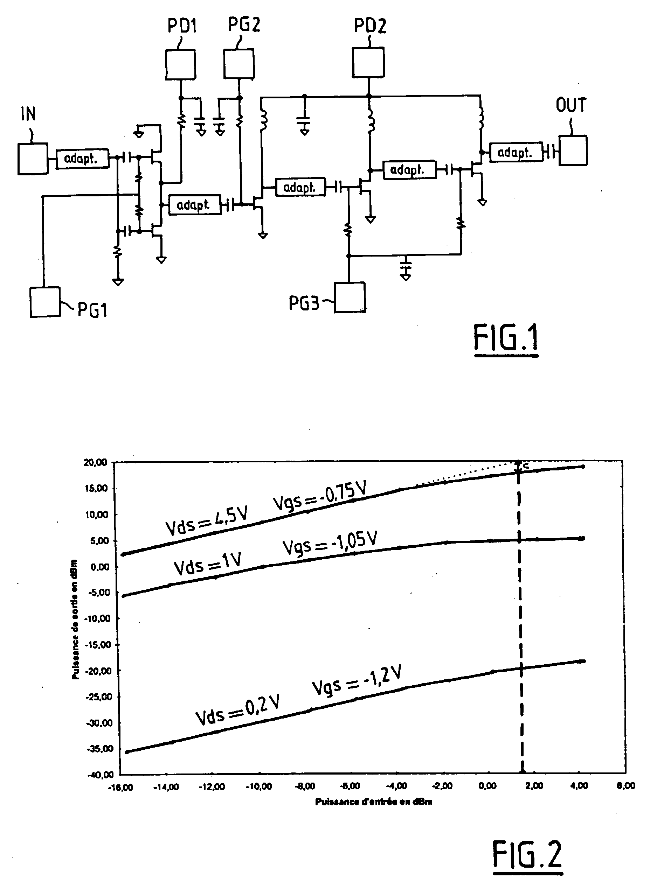

Considérant tout d'abord la figure 1, elle représente un schéma simplifié d'un amplificateur de puissance. Cet amplificateur est par exemple le HMMC 5040 fabriqué par Hewlett-Packard. Il comporte une entrée de signal IN, une entrée de sortie OUT et cinq entrées de polarisation PG1, PG2, PG3, PD1, PD2 sur lesquelles sont appliquées les tensions de polarisation des transistors de cet amplificateur.

Sommairement, cet amplificateur comporte quatre étages d'amplification. Un bloc d'adaptation d'impédance est prévu entre chaque étage. Les tensions continues appliquées sur les entrées de polarisation PG1 et PD1 servent à polariser respectivement la grille et le drain des transistors du premier étage de l'amplificateur. Les tensions appliquées sur les entrées PG2 et PG3 sont utilisées pour polariser respectivement la grille des transistors du deuxième et du troisième étage. Enfin, la tension appliquée sur l'entrée PD2 est utilisée pour polariser le drain des transistors des deuxième, troisième et quatrième étage.

Le niveau de puissance de sortie de cet amplificateur est réglé selon l'invention en agissant sur les tensions de polarisation des transistors de l'amplificateur. Dans la suite de l'exposé, les tensions appliquées sur les entrées PG1, PG2, PG3 sont prises égales, de même que les tensions appliquées sur les entrées PD1 et PD2, de manière à simplifier les explications et les figures. Vds désigne la tension de polarisation de drain des transistors et Vgs la tension de polarisation de grille.

La figure 2 montre la puissance de sortie de l'amplificateur de la figure 1 en fonction de la puissance d'entrée pour trois polarisations différentes. On voit directement sur cette figure que, pour une puissance d'entrée donnée, on peut régler le niveau de puissance de sortie en modifiant la polarisation des transistors de l'amplificateur.

Les différentes courbes de la figure 2 sont obtenues en faisant varier la tension Vds (tension drain-source) et la tension Vgs (tension grille-source) des transistors de l'amplificateur. On pourrait envisager de ne modifier que la tension Vds. Toutefois, il est préférable de faire varier également la tension Vgs de façon à garantir un meilleur comportement en température de l'amplificateur. Cet aspect sera développé plus loin dans la description.

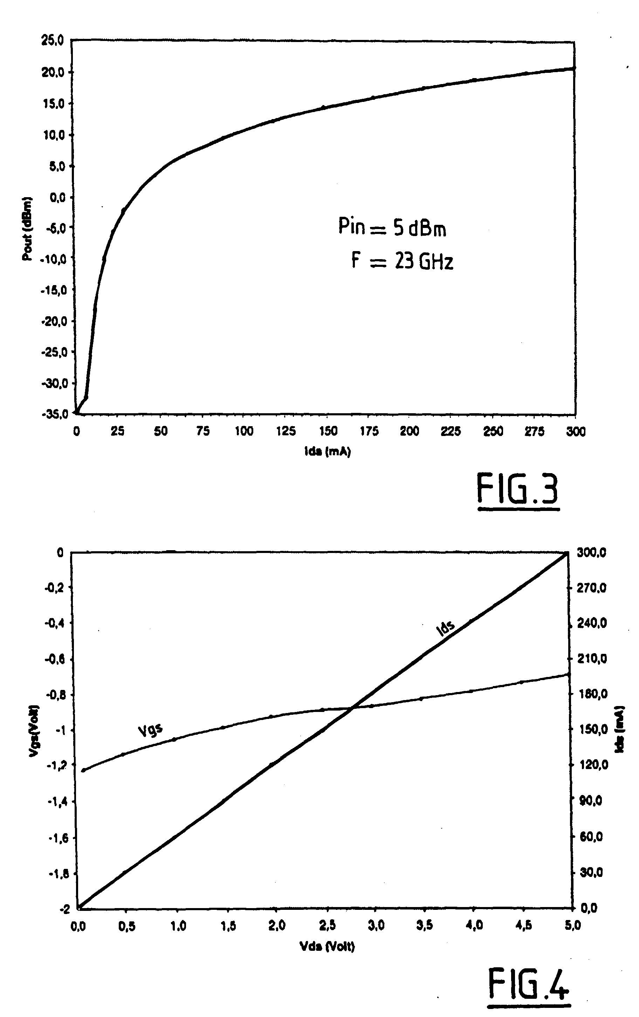

Les variations de Vgs et Vds entraîne une variation du courant drain-source Ids dans les transistors. La figure 3 montre une courbe de la puissance de sortie de l'amplificateur en fonction du courant Ids des transistors. Cette courbe a été obtenue avec un signal à l'entrée de l'amplificateur de puissance Pin égale à 5 dBm et de fréquence 23 GHz. La puissance de sortie croît à mesure que le courant Ids croît.

Les lois Vgs=f(Vds) et Ids=f(Vds) retenues pour un fonctionnement optimal de l'amplificateur sont illustrées à la figure 4. La loi Ids=f(Vds) qui a été retenue est linéaire.

A l'aide des figures 3 et 4, il est alors possible de déterminer les valeurs Vds et Vgs nécessaires pour obtenir un niveau de puissance de sortie Pout donné. Par exemple, pour Pout = 20dBm, il faut Ids = 300mA, c'est-à-dire Vds= 5V et Vgs = -0.7V.

De préférence, le niveau de compression est pris suffisamment élevé, de l'ordre de 5 dB, de manière à ce que le niveau de puissance de sortie varie peu sur la gamme des températures de fonctionnement de l'amplificateur. Le niveau de compression, référencé c sur l'une des courbes de la figure 2, est l'écart en dB entre la puissance obtenue en sortie de l'amplificateur s'il ne saturait pas et la puissance de sortie réelle pour une puissance d'entrée donnée.

Par ailleurs, pour que ce niveau de compression soit identique pour toutes les polarisations, il faut que le gain linéaire et la puissance de sortie de l'amplificateur chutent de manière identique à mesure que le courant Ids chute. C'est pourquoi, on agit à la fois sur la tension Vds (réglage de la puissance de sortie) et sur la tension Vgs (réglage du gain de l'amplificateur).

Les lois illustrées à la figure 4 ont par ailleurs été définies de façon à obtenir un produit d'intermodulation d'ordre 3, communément désigné par le terme IP3, constant à l'entrée de l'amplificateur.

## Revendications

1. Procédé de réglage du niveau de puissance de sortie d'un amplificateur de puissance, lequel amplificateur de puissance comporte une pluralité de transistors de puissance, caractérisé en ce qu'il consiste à agir sur la polarisation de drain (Vds) de ladite pluralité de transistors de l'amplificateur de puissance.

2. Procédé selon la revendication 1, caractérisé en ce qu'il consiste à agir en outre sur la polarisation de grille (Vgs) de ladite pluralité de transistors de l'amplificateur de puissance de manière à garantir de faibles variations du niveau de puissance de sortie sur la gamme des températures de fonctionnement de l'amplificateur.

3. Procédé selon l'une des revendications précédentes caractérisé en ce que le courant drain-source (Ids) et la tension drain-source (Vds) des transistors de l'amplificateur sont linéairement dépendants.

4. Procédé selon l'une des revendications précédentes caractérisé en ce que la tension grille-source (Vgs) et la tension drain-source (Vds) des transistors de l'amplificateur varient de façon identique à mesure que le courant drain-source (Ids) varie.

FIG.1

FIG.2

Pin = 5 dBm

F = 23 GHz

FIG.3

FIG.4

5

Office européen
des brevets

## RAPPORT DE RECHERCHE EUROPEENNE

Numéro de la demande

EP 98 46 0066

### DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|-----------|---------------------------------------------------------------------------------|-------------------------|-------------------------------------|
| X | US 5 182 527 A (ONODERA TETSUO ET AL) 26 janvier 1993 (1993-01-26) * colonne 14, ligne 62 - colonne 15, ligne 68; figure 7 * | 1,2 | H03G3/00 H03G1/00 |
| X | US 5 029 298 A (CHIBA YUTAKA ET AL) 2 juillet 1991 (1991-07-02) * le document en entier * | 1 | |
| X | PATENT ABSTRACTS OF JAPAN vol. 1995, no. 10, 30 novembre 1995 (1995-11-30) -& JP 07 170202 A (HITACHI LTD), 4 juillet 1995 (1995-07-04) * abrégé * | 1,2 | |
| A | WO 98 48510 A (ERICSSON TELEFON AB L M) 29 octobre 1998 (1998-10-29) * abrégé * | 1-4 | |

DOMAINES TECHNIQUES RECHERCHES (Int.Cl.7)

H03G

Le présent rapport a été établi pour toutes les revendications

| Lieu de la recherche | Date d'achèvement de la recherche | Examinateur |
|----------------------|-----------------------------------|-------------|
| LA HAYE | 5 novembre 1999 | Blaas, D-L |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

................................................................
& : membre de la même famille, document correspondant

EPO FORM 1503 03.82 (P04C02)

**ANNEXE AU RAPPORT DE RECHERCHE EUROPEENNE**
**RELATIF A LA DEMANDE DE BREVET EUROPEEN NO.**   EP 98 46 0066

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

05-11-1999

| Document brevet cité au rapport de recherche | | Date de publication | Membre(s) de la famille de brevet(s) | | Date de publication |
|---|---|---|---|---|---|
| US 5182527 | A | 26-01-1993 | JP | 3283717 A | 13-12-1991 |
| | | | JP | 2690595 B | 10-12-1997 |
| | | | JP | 4003625 A | 08-01-1992 |
| | | | JP | 4003608 A | 08-01-1992 |
| | | | JP | 4096057 A | 27-03-1992 |
| | | | JP | 5067939 B | 27-09-1993 |
| | | | JP | 2720591 B | 04-03-1998 |
| | | | JP | 4130804 A | 01-05-1992 |
| | | | US | 5126688 A | 30-06-1992 |
| US 5029298 | A | 02-07-1991 | JP | 2168731 A | 28-06-1990 |
| | | | JP | 2609310 B | 14-05-1997 |
| | | | GB | 2227621 A | 01-08-1990 |
| JP 07170202 | A | 04-07-1995 | AUCUN | | |
| WO 9848510 | A | 29-10-1998 | AU | 7089998 A | 13-11-1998 |
| | | | SE | 9701452 A | 19-10-1998 |

EPO FORM P0460

Pour tout renseignement concernant cette annexe : voir Journal Officiel de l'Office européen des brevets, No.12/82